# FASCICULE DE BREVET EUROPEEN

(11) **EP 1 664 926 B1**
(45) Date de publication et mention de la délivrance du brevet: **10.04.2013**
(21) Numéro de dépôt: 04816132.7
(22) Date de dépôt: 15.09.2004
(51) Int. Cl.: G03F 7/00, B29C 59/04

(54) **PROCEDE DE MICRO-LITHOGRAPHIE UTILISANT UN MASQUE A SURFACE COURBE, ET UN MASQUE CORRESPONDANT**
MIKROLITHOGRAPHIE-VERFAHREN MIT EINER MASKE MIT GEKRÜMMTER OBERFLÄCHE, SOWIE MASKE HIERFÜR
MICROLITHOGRAPHY METHOD USING A MASK WITH CURVED SURFACE AND MASK THEREFOR

(30) Priorité: 17.09.2003 FR 0350561
(43) Date de publication de la demande: 07.06.2006
(73) Titulaire: Commissariat à l'Énergie Atomique et aux Énergies Alternatives, 75015 Paris (FR)
(72) Inventeur: GUIBERT, Jean-Charles, F-38960 SAINT ETIENNE DE CROSSEY (FR)
(74) Mandataire: Ahner, Philippe
(86) Numéro de dépôt international: PCT/FR2004/050433
(87) Numéro de publication internationale: WO 2005/026838

(56) Documents cités:
- EP-A- 0 845 710
- DE-A1- 19 913 683
- US-A- 5 281 511
- US-A1- 2003 104 287
- US-B1- 6 375 870
- US-B1- 6 416 908
- RUCHHOEFT P ET AL: "Patterning curved surfaces: Template generation by ion beam proximity lithography and relief transfer by step and flash imprint lithography" JOURNAL OF VACUUM SCIENCE AND TECHNOLOGY: PART B, AMERICAN INSTITUTE OF PHYSICS. NEW YORK, US, vol. 17, no. 6, novembre 1999 (1999-11), pages 2965-2969, XP002206574 ISSN: 0734-211X
- ROGERS J A ET AL: "Printing, molding, and near-field photolithographic methods for patterning organic lasers, smart pixels and simple circuits" SYNTH. MET. (SWITZERLAND), SYNTHETIC METALS, 1 NOV. 2000, ELSEVIER, SWITZERLAND, vol. 115, no. 1-3, 1 novembre 2000 (2000-11-01), pages 5-11, XP002279750 ISSN: 0379-6779
- ROOS N ET AL: "Nanoimprint lithography with a commercial 4 inch bond system for hot embossing" PROCEEDINGS OF THE SPIE - THE INTERNATIONAL SOCIETY FOR OPTICAL ENGINEERING SPIE-INT. SOC. OPT. ENG USA, vol. 4343, 2001, pages 427-435, XP002317296 ISSN: 0277-786X cité dans la demande

## Description

### DOMAINE TECHNIQUE ET ART ANTERIEUR

L'invention concerne les techniques de lithographie permettant de reproduire des motifs de petites tailles sur un substrat. La taille des motifs concernés par cette invention est par exemple inférieure à 10 microns.

L'invention, de par la taille des motifs mis en oeuvre, s'applique notamment au domaine des micro et nanotechnologies. Diverses applications industrielles peuvent être visées, par exemple la fabrication d'écrans plats, de mémoires, de nanosystèmes, de microsystèmes ou de bio-puces.

Différentes techniques de lithographies sont connues et utilisées aujourd'hui dans l'industrie. La plupart demandent l'emploi d'équipements très coûteux de type photorépéteur en ultra-violet profond à la longueur d'onde de 248, 193 ou 157nm ou l'emploi de rayonnements X mous à la longueur d'onde de 13nm ou de machines à faisceaux d'électrons. Ces équipements peuvent valoir d'une dizaine à plusieurs dizaines de millions d'euros.

Certaines techniques à bas coût commencent à apparaître, et elles font appel à des techniques d'embossage, d'encrage ou d'impression connues dans l'imprimerie ou la mise en forme des matières plastiques. On pourra par exemple se reporter à l'article de S.Y. Chou et al., Applied Physics Letters, 67(21),P 3114-3116, 1995.

Cependant ces techniques sont limitées en résultat à cause de problèmes liés à la résolution et à son homogénéité. En effet, après fabrication par lithogravure d'un masque portant les motifs à reproduire, il faut mettre en contact de manière la plus parfaite possible le substrat et le masque ; cette étape, difficile sur des surfaces de l'ordre de quelques cm², est pratiquement impossible pour des surfaces supérieures à quelques dizaines de cm². Il faut en effet aligner et superposer, puis mettre en contact de manière homogène deux surfaces globalement planes, mais dont les surfaces ne sont cependant pas identiques. Il s'ensuit un défaut d'homogénéité dans la résolution obtenue. Diverses publications ont mis en évidence ce type de problème par exemple dans les différents articles du « Proceedings of the International workshop on nanoimprint lithography, 16-17 janvier 2002, Université de Lund, Suède » et aussi dans l'article de N. Roos et al. intitulé « Nanoimprint lithography with a commercial 4 inch bond system for hot embossing », SPIE 2001 Emerging Technologies ainsi que dans l'article intitulé « Roller nanoimprint lithography » T. Hua et al., JVST B 16 (6) (1998) 3926-3928 ou dans l'article de S.Y. Chou et al. déjà cité ci-dessus.

Il se pose donc le problème de trouver sur un nouveau procédé, de préférence plus simple de mise en oeuvre, et permettant de résoudre les problèmes mentionnés ci-dessus.

Il se pose également le problème de trouver un procédé compatible avec une structure plane telle qu'une structure SOI.

### EXPOSÉ DE L'INVENTION

L'invention concerne d'abord un procédé de préparation d'un masque de lithographie, comportant :
- une étape de réalisation de motifs sur un substrat ou un masque plan,
- une étape de report des motifs sur un support courbe ou présentant localement ou en au moins un point ou une zone de sa surface au moins une courbure non nulle.

La zone à courbure non nulle a par exemple une superficie d'au moins 0,5 ou 1 cm², ou de l'ordre du cm², par exemple comprise entre 0,5 cm² et 10 cm².

L'invention propose un procédé de réalisation d'un masque, dont la surface n'est pas plane du fait d'un report d'un masque initialement plan sur un support au moins localement courbe. Différentes formes de support à courbure non nulle peuvent convenir, par exemple la surface extérieure d'un cylindre.

Après report, il est possible de mettre en contact, de manière progressive et contrôlée, la surface d'un substrat avec la surface du masque.

Le problème d'homogénéité rencontré ne se pose donc plus car on revient au cas de mise en contact de deux surfaces de quelques cm².

En outre l'invention permet d'éviter la réalisation d'un masque directement sur une surface courbe, réalisation difficile à mettre en oeuvre.

Le masque plan peut être par exemple en Silicium ou en dioxyde de silicium.

Il peut aussi avoir une structure SOI, comportant une couche d'un matériau semiconducteur, une couche enterrée d'isolant et un substrat.Dans ce dernier cas, une étape d'amincissement du substrat de la structure SOI peut en outre être prévue.

L'étape de report peut comporter préalablement un amincissement du substrat plan, puis l'installation d'un substrat poignée.

Le support courbe peut quant à lui être en métal, ou en verre ou en matériau plastique.

Des moyens peuvent être prévus dans le support courbe pour réaliser une déformation locale de ce support.

L'invention concerne aussi un masque de lithographie comportant un support présentant une courbure non nulle en au moins un point de sa surface, et un substrat en Silicium ou en silice comportant une pluralité de motifs appliqués contre cette surface.

### BRÈVE DESCRIPTION DES DESSINS

La figure 1 représente schématiquement une étape de lithographie par faisceau d'électrons,
la figure 2 représente le masque plan, après lithographie,
les figures 3A à 3C représentent diverses étapes de report,
la figure 4 représente un détail d'un masque sur sa surface de support courbe, après report,
les figures 5A à 5C représentent un marquage d'un substrat à l'aide d'un masque selon l'invention,
la figure 6 représente une structure SOI.

### EXPOSÉ DÉTAILLÉ DE MODES DE RÉALISATION DE L'INVENTION

L'invention met tout d'abord en oeuvre une première étape de réalisation de motifs sur un masque plan.

Une technique de lithographie peut être utilisée, par exemple par faisceau d'électrons.

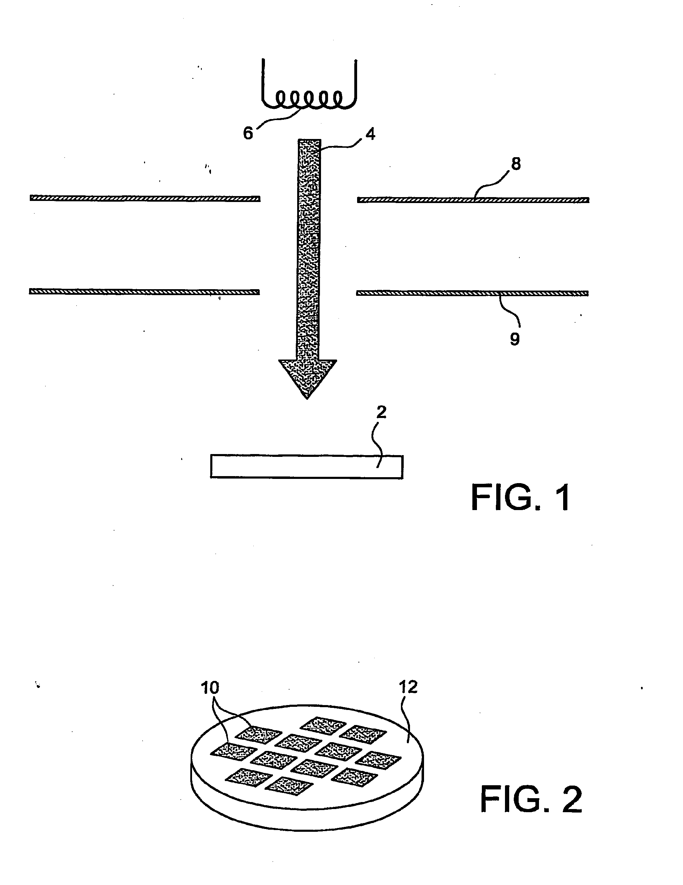

La figure 1 représente schématiquement un masque 2 sur lequel des motifs doivent être écrits à l'aide d'un tel faisceau d'électrons 4 d'un appareil de lithographie.

Le faisceau est produit par une source 6, telle qu'un filament en W, ou LaB₆ ou par TFE (« thermal field effect » ou effet de champ thermique) est dirigé et focalisé, à l'aide de lentilles électro magnétiques 8, 9, vers le masque 2.

L'équipement de lithographie est par exemple un équipement de lithographie par contact muni de moyens de déplacement et/ou de rotation du substrat ou du masque 2.

Cette première étape permet d'obtenir des motifs gravés 10 sur un substrat 12, comme illustré sur la figure 2. La largeur L de chaque motif peut être inférieure à 10µm, par exemple comprise entre 10nm et 100nm (notamment en vue de la réalisation de micro-pointes dans les écrans plats) ou entre 100nm et 5µm. Pour une application dans le domaine des mémoires magnétiques L sera comprise entre 10nm et 20nm. Pour une application dans le domaine des transistors L pourra être par exemple comprise entre 1µm et 10µm.

Il est ensuite procédé au report de ces motifs sur un support courbe ou présentant au moins une courbure non nulle en au moins un point ou une zone de sa surface ou sur toute sa surface ou sur une zone de taille comparable ou sensiblement égale à celle des motifs gravés.

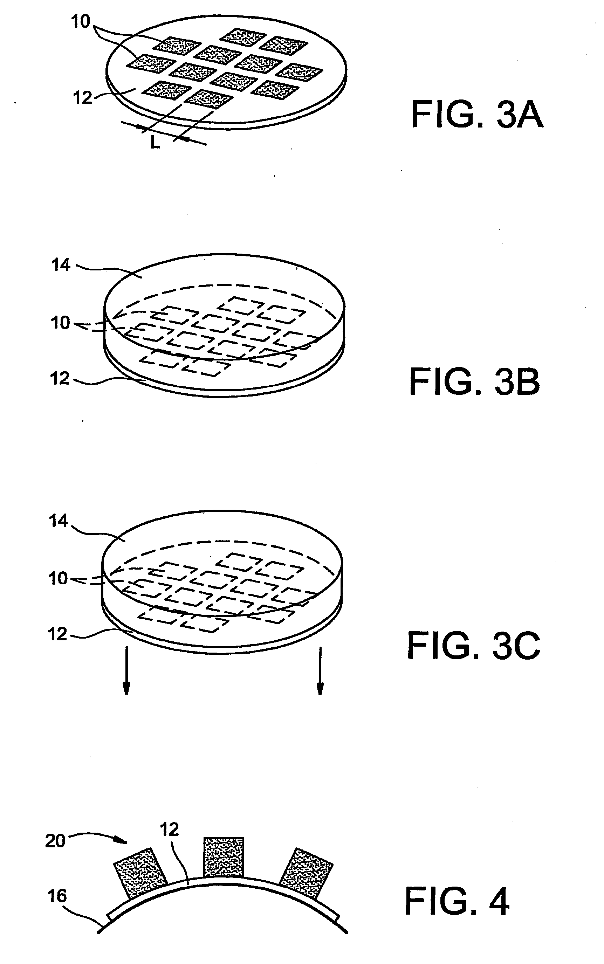

A cet effet, il peut être préalablement procédé à un amincissement du substrat 12 (FIG.3A), à l'installation d'un substrat 14 dit « poignée » (FIG. 3B), pris au report de l'ensemble sur un support 16 présentant une telle courbure (FIG. 3C). Selon l'exemple de la figure 3C, le support 16 présente une portion cylindrique, vue en coupe sur cette la figure.

On obtient ainsi un masque courbe 20 dont un détail est représenté sur la figure 4.

L'exemple de réalisation donné permet donc de fabriquer un masque courbe à l'aide de deux technologies, la lithographie et le report de couche.

La fabrication de petits motifs directement sur une surface de masque « courbe » est difficile à mettre en oeuvre ; en particulier , dans un masqueur électronique pour la lithographie, ces difficultés sont liées à des problèmes de profondeur de champ : le faisceau électronique ne garde pas la même dimension quand on se déplace sur sa longueur.

Selon l'exemple ci-dessus, l'étape de lithogravure est donc d'abord effectuée sur un masque plan dans un matériau usuel pour la lithographie par faisceaux d'électrons, par exemple le Silicium ou l'oxyde de silicium, puis la couche imagée est détachée et reportée sur un support au moins localement courbe.

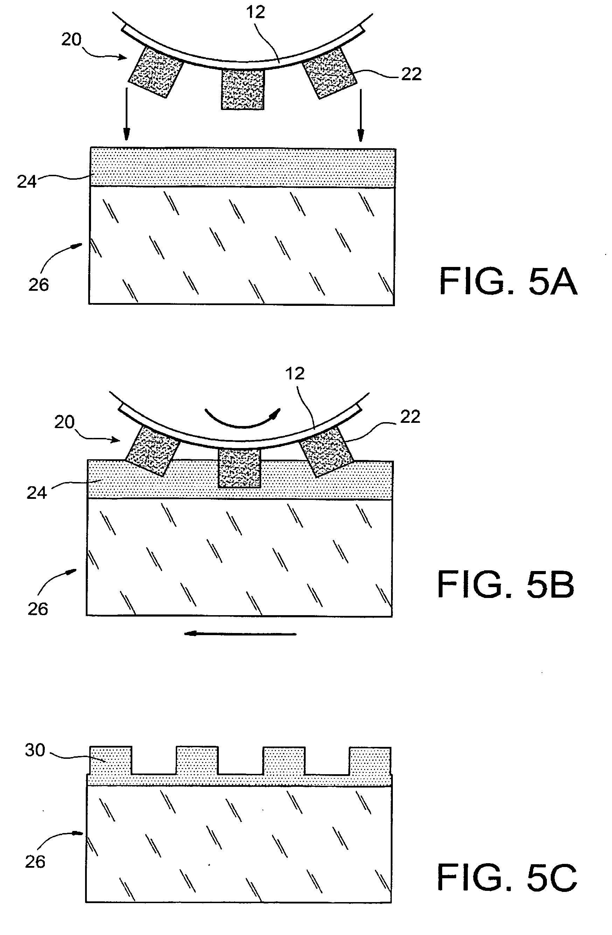

Les figures 5A à 5C représentent l'utilisation d'un tel masque.

Le masque courbe 20, dont les motifs sont désignés globalement par la référence 22, est mis en contact avec la couche superficielle 24 (par exemple : en résine polymère) d'un substrat 26 (par exemple en Silicium ou dioxyde de silicium).

Puis (figure 5B), il est procédé à la rotation du masque et/ou au déplacement du substrat 26.

Les surfaces en contact, respectivement du masque et du substrat, ont une surface de l'ordre du cm², par exemple comprise entre 0,5 cm² et 10 cm².

Il en résulte (figure 5C), après enlèvement du masque 20, un substrat 26 portant une image 30 en surface.

Le matériau du masque 2 est de préférence adapté au report c'est-à-dire qu'il a une inactivité chimique envers le substrat 26, et une souplesse suffisante dans l'épaisseur utilisée pour être reporté sur une surface courbe. Le silicium, ou la silice sont des matériaux présentant ce type de propriétés, ainsi que le nitrure.

Mais de préférence, on utilise un substrat de type SOI, la gravure étant réalisée dans la couche superficielle de Silicium.

Les structures SOI permettent usuellement la réalisation de certains composants semiconducteurs. De telles structures sont par exemple décrites dans le document FR 2681472.

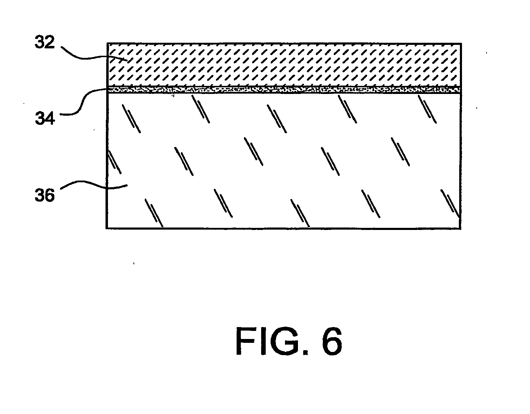

Comme illustré sur la figure 6, une structure SOI comporte une couche 32 de matériau semiconducteur, par exemple du Silicium monocristallin, dans laquelle peuvent être réalisés les composants proprement dits, et sous laquelle se trouve une couche enterrée 34 d'isolant, par exemple du dioxyde de silicium. L'ensemble repose sur un substrat 36, lui aussi en matériau semiconducteur, par exemple en Silicium.

Typiquement, la couche superficielle 32 a par exemple une épaisseur d'environ 10 à 1000nm (elle peut aussi être de plus de 1µm), tandis que la couche 34 a une épaisseur de l'ordre de quelques centaines de nm, par exemple 400nm.

Le support courbe 16 du masque peut-être réalisé dans différents matériaux choisis pour leur propriété de rigidité (tout métal ou verre) ou alors pour leur facilité de mise en forme. Un support plastique (par exemple : Polypropylène, ou PVC, ...), peut aussi être utilisé, la déformation de ce type de matériau permettant un meilleur contact entre le masque et le substrat.

D'autre part, des dispositifs, de type microsystèmes (par exemple un actionneur électrostatique de piézoélectrique), peuvent être fixés à l'intérieur du support courbe pour permettre une déformation locale du support, et donc un meilleur placement des motifs à reproduire.

A titre d'exemple, un masqueur électronique Leica VB6HR est utilisé pour écrire des motifs de 50nm sur une tranche de silicium sur isolant (SOI) de 200mm de diamètre. Après l'étape de lithographie, la couche supérieure de silicium, d'une épaisseur de 100nm, est décollée du substrat par une méthode décrite dans le document FR - 02 03909, qui met en oeuvre une implantation ionique puis une fracture, ainsi que l'utilisation d'une poignée. Puis elle est reportée sur un support courbe en verre. Ce support est par exemple un cylindre d'un diamètre au moins égal à 200/3.14=64 mm.

L'étape de report de l'image par impression pourra alors se faire à une température comprise entre 20°C et 250°C, en exerçant une pression comprise entre 300 et 4800psi, et pour une vitesse de rouleau comprise entre 0.5 et 1.5 cm/minute.

L'invention permet de mettre en oeuvre une étape de lithographie homogène de motifs sub-microniques avec des équipements de bas-coût, grâce à l'utilisation d'un masque courbe.

Des exemple d'étapes de transfert d'élements d'un support vers un autre support (permettant de créer un système décollable) et de décollement de deux éléments (permettant de réaliser une libération) sont décrites respectivement dans FR-2 781 925 et FR-2 796 491 et peuvent être utlisées dans le cadre de l'invention, notamment dans les exemples donnés ci-dessus.

## Revendications

1. Procédé de préparation d'un masque de lithographie, permettant de reproduire par contact des motifs (30), comportant :
- une étape de réalisation d'un masque plan (12) comportant des motifs (10), ayant une structure SOI, comportant une couche d'un matériau semiconducteur, une couche enterrée (34) d'isolant et un substrat (36),
- une étape de mise en contact du masque plan (12) sur un support (16) ayant une courbure non nulle en au moins un point de sa surface, de sorte à former un masque courbe (20) comportant des motifs (22) sur ledit support (16).

2. Procédé selon la revendication 1, les motifs étant réalisés par lithographie par faisceau d'électrons (4).

3. Procédé selon la revendication 1 ou 2, comportant en outre une étape d'amincissement du substrat (36) de la structure SOI.

4. Procédé selon l'une des revendications 1 à 3, l'étape de report comportant préalablement un amincissement du masque plan (12), puis l'installation d'un substrat (14) poignée.

5. Procédé selon l'une des revendications 1 à 4, le support courbe (16) étant en métal, ou en verre ou en matériau plastique.

6. Procédé selon l'une des revendications 1 à 5, des moyens permettant de réaliser une déformation locale du support (16) à courbure non nulle.

7. Procédé selon l'une des revendications 1 à 6, les motifs (10) ayant une dimension maximale comprise entre 50nm et 10µm.

8. Masque de lithographie courbe (20) comportant un support (16) présentant une courbure non nulle en au moins un point de sa surface, et un substrat (12), en Silicium ou en silice ou en nitrure, comportant une pluralité de motifs (10) et appliqué contre cette surface.

9. Masque selon la revendication 8, le support étant en métal ou en verre ou en matériau plastique.

10. Masque selon l'une des revendications 8 ou 9, comportant en outre des moyens pour induire une déformation locale dudit support (16).

## Claims

1. Process for preparing a lithographic mask, in order to reproduce patterns (30) by contact comprising:
- a stage for making a plane mask (12) comprising patterns (10), that has an SOI structure, comprising a layer of semiconductor material, a buried layer (34) of insulant and a substrate (36),
- a stage for contacting said plane mask on a support (16) that has a non-nil curvature on at least one point of its surface, so as to make a curved mask having patterns (22) on said support (16).

2. Process according to claim 1, the patterns being made by electron beam lithography (4).

3. Process according to claim 1 or 2, additionally comprising a stage for thinning the substrate (36) of the SOI structure.

4. Process according to one of claims 1 to 3, the transfer stage comprising previously a thinning of the plane mask (12), then the installation of a dandle substrate (14).

5. Process according to one of claims 1 to 4, the curved support (16) being of metal, or glass or plastic material.

6. Process according to one of claims 1 to 5, with means allowing a local deformation to be made of the support (16) with the non-nil curvature.

7. Process according to one of claims 1 to 6, the patterns (10) having a maximum dimension of between 50 nm and 10 µm.

8. Curved lithographic mask (20) comprising a support (16) that has a non-nil curvature on at least one point of its surface, and a substrate (12), of Silicon or silica or nitride, comprising a plurality of patterns (10) and applied against this surface.

9. Mask according to claim 8, the support being of mental or glass or plastic material.

10. Mask according to one of claims 8 or 9, additionally comprising means for inducing a local deformation of said support (16).

## Patentansprüche

1. Verfahren zur Herstellung einer Lithographie-Maske, welche es ermöglicht, Muster (30) durch Kontakt zu reproduzieren, umfassend:
- einen Schritt der Herstellung einer ebenen Maske (12), welche Muster (10) umfasst, mit einer SOI-Struktur, die eine Schicht aus einem halbleitenden Material, eine vergrabene Isolatorschicht (34) und ein Substrat (36) umfasst,
- einen Schritt, die ebene Maske (12) in Kontakt mit einem Träger (16) zu bringen, der in wenigstens einem Punkt seiner Oberfläche eine von Null verschiedene Krümmung aufweist, um eine gekrümmte Maske (20) mit Mustern (22) auf dem Träger (16) zu bildern.

2. Verfahren nach Anspruch 1, wobei die Muster durch Elektronenstrahl-Lithographie (4) hergestellt werden.

3. Verfahren nach Anspruch 1 oder 2, weiterhin umfassend einen Schritt, das Substrat (36) der SOI-Struktur dünner zu machen.

4. Verfahren nach einem der Ansprüche 1 bis 3, wobei der Übertragungsschritt umfasst, die ebene Maske (12) vorab dünner zu machen, und dann ein Griff-Substrat (14) zu installieren.

5. Verfahren nach einem der Ansprüche 1 bis 4, wobei der gekrümmte Träger (16) aus Metall oder aus Glas oder aus Kunststoff besteht.

6. Verfahren nach einem der Ansprüche 1 bis 5, wobei Mittel ermöglichen, eine lokale Verformung des Trägers (16) mit einer von Null verschiedenen Krümmung durchzuführen.

7. Verfahren nach einem der Anspruche 1 bis 6, wobei die Muster (10) eine maximale Abmessung zwischen 50 nm und 10 µm haben.

8. Gekrümmte Lithographie-Maske (20), umfassend einen Träger (16), der in wenigstens einem Punkt seiner Oberfläche eine von Null verschiedene Krümmung aufweist, und ein Substrat (12) aus Silizium oder aus Siliziumdioxid oder aus Nitrid, welches eine Mehrzahl von Mustern (10) umfasst und an der Oberfläche anliegt.

9. Maske nach Anspruch 8, wobei der Träger aus Metall oder aus Glas oder aus Kunststoff besteht.

10. Maske nach einem der Ansprüche 8 oder 9, weiterhin umfassend Mittel, um eine lokale Verformung des Trägers (16) herbeizuführen.
